# EUROPEAN PATENT SPECIFICATION

(11) **EP 2 438 663 B1**
(45) Date of publication and mention of the grant of the patent: **31.12.2014**
(21) Application number: 10728441.6
(22) Date of filing: 22.05.2010
(51) Int. Cl.: H01S 5/323, H01S 5/20, H01S 5/32

(54) **LASER DIODE AND METHOD OF FABRICATION THE LASER DIODE**
LASERDIODE UND VERFAHREN ZUR HERSTELLUNG DER LASERDIODE
DIODE LASER ET PROCÉDÉ DE FABRICATION D'UNE DIODE LASER

(30) Priority: 30.05.2009 PL 38814909
(43) Date of publication of application: 11.04.2012
(73) Proprietor: Instytut Wysokich Cisnien Polskiej Akademii Nauk, 01-142 Warszawa (PL)
(72) Inventor: PERLIN, Piotr, PL-03-984 Warszawa (PL); SARZYNSKI, Marcin, PL-05-091 Zabki (PL); HOLC, Katarzyna, 79108 Freiburg (DE); LESZCZYNSKI, Michal, PL-05-500 Mysiadlo (PL); CZERNECKI, Robert, PL-43-284 Kalina (PL); SUSKI, Tadeusz, PL-05-505 Nowy Prazmów (PL); BOCKOWSKI, Michal, PL-01-684 Warszawa (PL); GRZEGORY, Izabella, PL-01-886 Warszawa (PL); LUCZNIK, Boleslaw, PL-05-119 Legionowo (PL)
(74) Representative: Adamczyk, Piotr
(86) International application number: PCT/PL2010/050018
(87) International publication number: WO 2010/140909

(56) References cited:
- US-A1- 2002 109 146
- US-A1- 2004 065 889
- US-A1- 2008 192 788
- POROWSKI S ET AL: "Thermodynamical properties of III-V nitrides and crystal growth of GaN at high N2 pressure" JOURNAL OF CRYSTAL GROWTH, ELSEVIER, AMSTERDAM, NL LNKD- DOI:10.1016/S0022-0248(97)00072-9, vol. 178, no. 1-2, 1 June 1997 (1997-06-01), pages 174-188, XP004084984 ISSN: 0022-0248
- PERLIN P ET AL: "Application of a composite plasmonic substrate for the suppression of an electromagnetic mode leakage in InGaN laser diodes" APPLIED PHYSICS LETTERS AMERICAN INSTITUTE OF PHYSICS USA, vol. 95, no. 26, 28 December 2009 (2009-12-28), XP002606108 ISSN: 0003-6951
- TRAN N H ET AL: "Influence of oxygen on the crystalline-amorphous transition in gallium nitride films" JOURNAL OF PHYSICAL CHEMISTRY B ACS USA, vol. 109, no. 39, 6 October 2005 (2005-10-06), pages 18348-18351, XP002606039 ISSN: 1089-5647

## Description

### Technical Field

The subject of this invention is a AlInGaN laser diode and a method of fabrication such laser diode.

### Background Art

Present-day semiconductor laser diodes are usually fabricated as Separate Confinement Heterostructures, which means that the confinement for carriers and for the optical mode are determined separately by applying materials which differ in refractive index. A sequence of thin semiconductor films is deposited on a monocrystalline substrate, for example on GaAs, InP or GaN. A detail description of the method can be found, for example in: L. A. Coldren, S. W. Corzine, "Diode Lasers and Photonic Integrated Circuits" (Wiley Series in Microwave and Optical Engineering). The active region of such devices consist of quantum wells, bounded by quantum barriers. The electromagnetic mode propagates within the waveguide, which consists of high index layers enclosing the active region and which is then surrounded by low index layers. In the subsequent part of this description "laser waveguide" will be strictly referred to the transversal direction, which is the direction of the structure growth. The electromagnetic mode, or simply the mode will be referred to a specific spatial field distribution, which constitutes a solution to the wave equation in the waveguide. The lateral confinement can be obtained by any other means (index guiding, gain guiding, mesa, buried ridge) without loss of generality of the subsequently given reasoning/arguments. The electron blocking layer does not have to necessarily appear in all of the constructions. In case of lasers based on group III nitrides, emitting light within the spectral range between 400-500 nm, the above mentioned layers are realized using a specific method, which is described, among others, in: S. Nakamura, J. Mater. Res. 14, 2716 (1999) and in the patent publication US 6,838,693 B2. A 50 to 200 µm thick crystalline gallium nitride is used as a substrate. Cladding layers consist of aluminum-gallium nitride, AlₓGa₁₋ₓN, for which x is from 0.05 to 0.12. The thickness of the cladding layers is from 0.5 to 5 µm. The bottom cladding layer is doped with silicon with doping level from 5 x 10¹⁹cm⁻³ to 1 x 10²⁰cm⁻³. Waveguide layers usually consist of gallium nitride of thicknesses from 0.05 to 0.15 µm. The bottom waveguide can be silicon doped, and the upper waveguide can be magnesium doped. Both waveguide layers may also be undoped. The electron blocking layer is made of AlₓGa₁₋ₓN, where x is from 0 to 0.3. The quantum well layer, in case of lasers emitting in the range of 400-500 nm is made of InₓGa₁₋ₓN, where x ranging from 0 to 0.3 and its thickness ranges from 2 to 10 nm. The upper cladding layer is made of AlₓGa₁₋ₓN, for which x is from 0.09 to 0.35 and its thickness is from 8 to 30 nm. In case of infrared lasers fabricated on a GaAs substrate, the waveguide is made of GaAs layers and AlGaAs cladding layers of high aluminum content. The high aluminum composition ensures the high refractive index contrast between the GaAs-core and the AlGaAs claddings. For example, laser emitting infrared radiation of the wavelength of around 900 nm that uses claddings with 50% aluminum content has the refractive index contrast of around 9% between the GaAs waveguide and AlGaAs claddings. The advantage of the GaAs-AlAs system is that the both compounds have closely matched lattice constants (the difference is only 0.2%). Due to this fact the whole structure can be strain-free. The situation is very different in case of gallium nitride structures. AlGaN, which serves for cladding layers, is lattice-mismatched to gallium nitride substrates (the lattice mismatch between GaN and AIN is of 2.5%). In consequence a strong tensile strain appears in AlGaN layers. If we go beyond a certain value of combination of the layer thickness and composition, a relaxation of strain occurs. This relaxation is realized through macroscopic cracking of the structure and/or generation of misfit dislocations. The maximal thickness and composition of AlGaN can be deduced from literature, for example from the paper: "Elimination of AlGaN epilayer cracking by spatially patterned AIN mask" by Marcin Sarzyński et al. Appl. Phys. Lett. 88, 121124 (2006), according to which obtaining a 40% AlGaN layer of thickness of 1 µm without cracking and other defects is not possible. Additional problem arising in nitride lasers, and which is a consequence of weak vertical confinement of the mode, is the mode leakage into the GaN substrate. Gallium nitride comprises both the waveguide core and the substrate and thus a strong tendency to the leaking of part of the mode into the substrate is observed, which at the same time significantly delimits the r factor describing the overlap between the optical mode and the active region. In order to avoid claddings, for example 2 µm thick with 5% AlGaN. From the paper Appl. Phys. Lett. 88, 121124 (2006) a conclusion can be made that such layer would not be cracked, however the amount of elastic energy accumulated in this layer must certainly lead to macroscopic bowing of the whole structure, which has detrimental influence on laser structure processing feasibility. US2008/0192788 A1 and US2002/0109146A1 also disclose nitride semiconductor laser diodes.

### Disclosure of Invention

An object of the invention was to fabricate a laser structure featuring better optoelectronic parameters, such as the threshold current and improved structure quality leading to better reliability of the device.

The object is realized through a laser diode based on a AlInGaN alloy. The structure consists of the bottom cladding layer, which has a n-type conductivity, a bottom waveguide layer having also n-type conductivity, a light emitting (active) layer, an electron blocking layer of p-type conductivity, an upper waveguide layer and a subcontact layer, doped with acceptors with concentration level above 10²⁰cm⁻³. In such diode the bottom cladding layer is made of GaOₓN₁₋ₓ alloy, where x>0.0005, a material of the bottom cladding layer has the refractive index at least one percent smaller (at wavelength of 405 nm) than the refractive index of a material comprising the upper and the bottom waveguide layer, and the bottom cladding layer thickness equals at least 10 µm.

In one variant of the laser diode according to the invention the diode comprises first additional layer not thinner than 0.8 µm, which is made of Al_{y}Ga_{1-y}N, where 0<y<0.1, and which is placed between the bottom cladding layer and the bottom waveguide layer.

In another variant of the laser diode according to the invention the diode comprises two additional layers, the second and the third, which are placed below the bottom cladding layer. The second bottom cladding layer, made of 100 to 400 µm thick gallium nitride, is placed directly below the bottom cladding layer. The third additional layer, which is made of GaOₓN₁₋ₓ, where x > 0.0005, is placed directly below the second additional layer.

In yet another variant of the laser diode according to the invention the second and the third additional layer have dislocation density lower than 1 x 10⁷cm⁻².

A fabrication method of a laser diode based on AlInGaN alloy according to the invention relays on epitaxial growth of: a layer structure comprising at least the bottom cladding layer of n-type conductivity having at least one layer of GaOₓN₁₋ₓ, where x > 0.0005, a bottom waveguide layer of n-type conductivity, a light emitting layer, an electron blocking layer of p-type conductivity, an upper waveguide layer, an upper cladding layer of p-type conductivity and a subcontact layer doped with acceptors of concentration above 10²⁰cm⁻³. At least one of the layers of the GaOₓN₁₋ₓ, is obtained using a high pressure method of nitride solution in gallium at pressures of 800 MPa. This method is characterized by that the bottom cladding layer is fabricated as a three layer structure. This structure contains two GaOₓN₁₋ₓ layers obtained from a nitride solution in gallium using the high pressure method at pressure above 800 MPa, which are grown on the inner gallium nitride layer of thickness of 100 to 400 µm.

In a variant of the method according to the invention, in the fabricated three-layer structure of the bottom cladding layer, the upper GaOₓN₁₋ₓ layer has thickness from 2 to 100 µm.

The invention entirely eliminates the mode leakage into the substrate, improving the optical confinement factor r and also improves the flatness of the surface leading to easier device processing and to a decrease of structural defects in a laser due to reduction of the lattice mismatch between the material of the lower waveguide cladding and the materials of other layers, including waveguide layers.

### Brief Description of Drawings

The invention is presented in the accompanying drawings, where Fig.1, Fig.2 and Fig. 3 schematically show three embodiments of the laser structure according to the invention, while Fig.4 and Fig.5 show two optical characteristics of the laser diodes according to the invention.

### Mode for Carrying Out the Invention

Below have been presented three laser diode structures according to the invention and method of their fabrication.

### Example 1

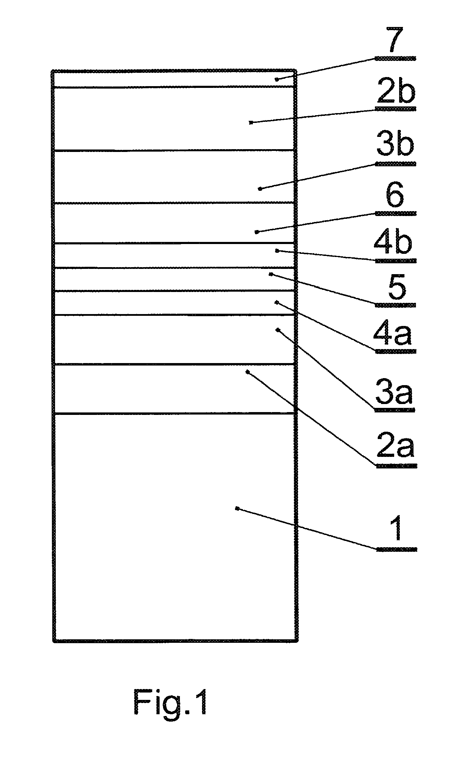

### Laser diode of lowered threshold current fabricated on uniform GaOₓN₁₋ₓ substrate, which was obtained in the high pressure growth process and of the structure presented in Fig. 1.

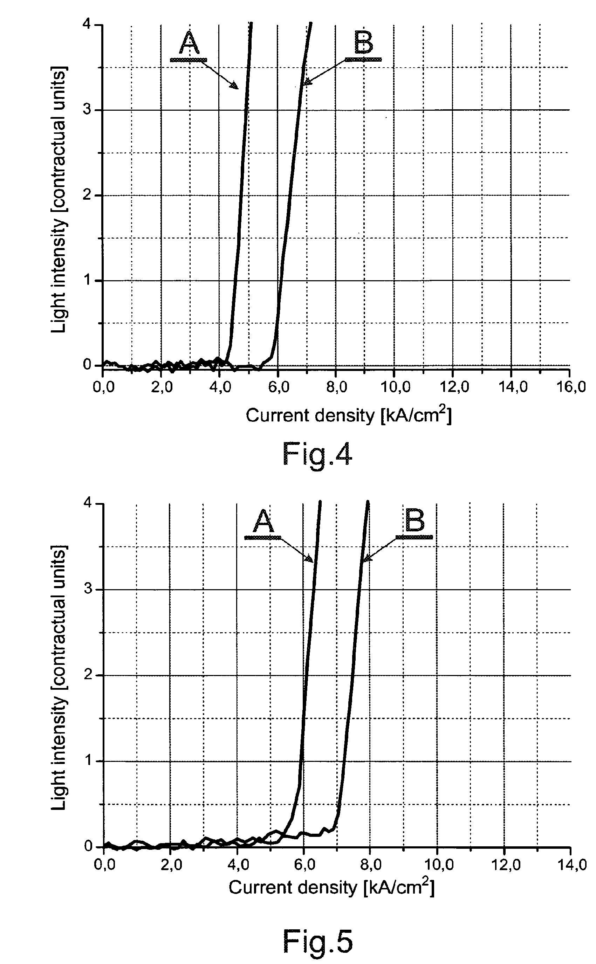

In first step a GaO_{0.0005}N₀.₉₉₉₅ substrate has been fabricated using the growth method from a nitride solution in gallium under the pressure of 1000 MPa and at temperature of 1500°C. The fabricated crystal has been cut and polished in order to obtain an optically flat platelet of typical thickness of 150-350 µm. The gallium site surface of the crystal, after a proper mechanocemical polishing, featured atomic flatness, visible as atomic steps in the image of the Atomic Force Microscope. The crystal surface was disoriented by at least 0.5 deg. with respect to the crystallografic c axis of the hexagonal Wurzite structure. This substrate is marked in Fig.1 using reference number 1. Next, the substrate 1 was placed in a MOVPE reactor, where a 600 nm thick Ga_{0.2}Al_{0.08}N layer 2a was grown at temperature about 1050°C and which was silicon-doped with the level of concentration reaching 5 x 10¹⁸cm⁻³. Then, applying the same temperature growth, was fabricated an undoped GaN layer 3a of thickness about 100 nm and serving as the lower waveguide layer. After decreasing the temperature to 820°C the active region with multi quantum wells made of In_{0.1}Ga_{0.9}N/In_{0.01}Ga_{0.99}N, and number of repetition of the multi-quantum-well was three (layers 4a, 5, and 4b have been made three times). Next, after rising the reactor temperature to 1050°C, an 350 nm electron blocking layer 6 of Al_{0.08}Ga_{0.98}N was fabricated. As next layers of the laser structure upper waveguide layer 3b and upper cladding layer 2b were grown. The growth of the structure was terminated in a thin subcontact layer 7 of GaN:Mg with magnesium concentration larger than 10²⁰cm⁻³. After termination the growth process, the reactor chamber was cooled down in nitrogen ambient. Next, the surfaces of the laser structure were patterned with metallic layers forming contacts to the n- and p- side of the crystal, in such a way that the upper contact was in a shape of a stripe of the length from 300 to 2000 µm and the width from 1 and 100 µm. Annealing of the contacts was performed under temperatures lower than 390°C. The laser can be etched with mesa, which then can be of 300-450 nm high, in order to improve lateral confinement of the electromagnetic mode. Using the GaOₓN₁₋ₓ substrate, the threshold current density has been lowered by about 30% (see fig 4, A - laser diode according to the invention, B-a known diode). Have been improved also near and far field patterns which indicate the mode leakage suppresion.

### Example 2

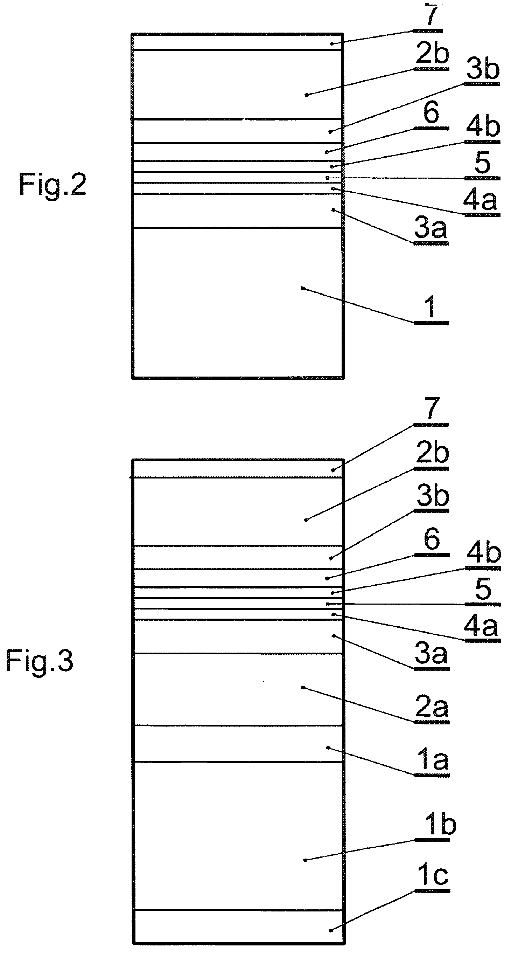

### Laser diode of lowered threshold current fabricated on uniform GaOₓN₁₋ₓ substrate, which was obtained in the high pressure growth process and of the structure presented in Fig.2.

In the first step a substrate 1 of *GaOₓN₁₋ₓ* was fabricated and prepared in a way described in Example 1. Next, the substrate 1 was placed in a MOVPE reactor, where at temperature about 1050°C an undoped 100 nm thick layer of GaN forming a lower waveguide layer 3a was fabricated. After decreasing the temperature to 820°C the active region with multi quantum wells of In_{0.1}Ga_{0.9}N/In_{0.01}Ga_{0.99}N was made, and the number of repetition of the multi-quantum-well was three (layers 4a, 5, and 4b were fabricated three times). Next the reactor temperature was risen to 1050°C and an electron blocking layer 6 of Al_{0.12}Ga_{0.88}N was fabricated. On the layer 6 an undoped GaN layer forming the upper waveguide 3b was grown. The next layer was the upper cladding layer 2b, which was made of 350 nm thick Al_{0.08}Ga_{0.98}N. The structure growth was terminated in a thin subcontact layer 7 of GaN:Mg with magnesium concentration larger than 10²⁰cm⁻³. After termination the growth process, the reactor chamber was cooled down in nitrogen ambient. The n- and p- side contacts were fabricated in the same way as described in Example 1. Also in this case the laser can be etched with mesa of 300-450 nm height, in order to improve lateral confinement of the electromagnetic mode.

### Example 3

### Laser diode of lowered threshold current fabricated on complex GaOₓN₁₋ₓ substrate, which was obtained in the high pressure growth process and of the structure presented in Fig.3.

In the first step of the laser diode structure fabrication, a silicon doped GaN crystal with the doping level of 5 x 10¹⁸cm⁻³ has been synthesized using HVPE method at temperature of 1050°C. The growth surface of this crystal was prepared in a way described in Example 1 and this substrate was marked in Fig.3 using reference number 1 b. The substrate 1 b was introduced into a high pressure reactor chamber, where using the growth method from a nitride solution in gallium under pressure of 1000 MPa and at temperature of 1500°C, on both sides of the HVPE seed GaO_{0.005}N_{0.995} layers were fabricated (layers 1a and 1c). After a mechanochemical polishing of the layers 1 a and 1 c, the substrate 1 was placed in a MOVPE reactor, where a silicon-doped GaO_{0.92}Al₀₀₈N layer 2a of a thickness of 600 nm was grown at temperature 1050°C. Next, at the same temperature an undoped 100 nm thick GaN layer forming the bottom waveguide 3a was fabricated. After decreasing the temperature to 820°C the active region with multi quantum wells of In_{0.1}Ga_{0.9}N/In_{0.01}Ga_{0.99}N, and the number of repetition of the multi-quantum-well was three (layers 4a, 5, and 4b were fabricated three times). Next, after rising the reactor temperature to 1050°C an electron blocking layer 6 of Al_{0.12}Ga_{0.88}N was fabricated, on which subsequently an undoped GaN layer forming the upper waveguide 3b was grown. Next layer was an upper cladding layer 2b, which was made of 350 nm thick Al_{0.08}Ga_{0.98}N. The structure growth was terminated in a thin subcontact layer 7 of GaN:Mg with magnesium concentration larger than 10²⁰cm⁻³. After termination the growth process, the reactor chamber was cooled down in nitrogen ambient. The n- and p- side contacts were fabricated in the same way as described in Example 1. Also in this case the laser can be etched with mesa of 300-450 nm height, in order to improve lateral confinement of the electromagnetic mode. Using the *GaOₓN₁₋ₓ* substrate, the threshold current density has been lowered by about 25% (see Fig.5, A - a laser diode according to the invention, B - a known diode). The improved near and far field patterns indicate the mode leakage suppresion.

## Claims

1. A laser diode based on AlInGaN alloy, comprising a bottom cladding layer (1) of n-type conductivity made of GaOₓN₁₋ₓ alloy, in which x>0.0005, a bottom waveguide layer (3a) of n-type conductivity, a light emitting layer (4a,5,46), an electron blocking layer (6) of p-type conductivity, an upper waveguide layer (3b) of p-type conductivity, an upper cladding layer (2b) of p-type conductivity and a subcontact layer (7), doped with acceptors with concentration level above 10²⁰cm⁻³, **characterized in that** thickness of the bottom cladding layer (1) is at least 10 µm and a material of the bottom cladding layer (1) possess the refractive index at least one percent lower (at the wavelength of 405 nm) than the refractive index of a material constituting the bottom waveguide layer (3a) and the upper (3b) waveguide layer.

2. The laser diode according to one of Claim 1, **characterized in that** it comprises a first additional layer (2a) of thickness not smaller than 0.8 µm, made of Al_{y}Ga_{1-y}N alloy for which 0<y<1, and situated between the bottom cladding layer (1) and the bottom waveguide layer (3a).

3. The laser diode according to Claim 1 or 2, **characterized in that** it comprises two additional layers, the second (1a) and the third (1c), situated below the bottom cladding layer (1), and **in that** directly under the bottom cladding layer (1) the second additional layer (1 a) of a gallium nitride seed of the thickness of 100 to 400 µm is located while directly underneath there is the third additional layer (1c) of 2 to 100 µm thick GaOₓN₁₋ₓ in which x>0.0005.

4. The laser diode according to Claim 3, **characterized in that** the second additional layer (1a) and the third additional layer (1c) have dislocation densities lower than 1 x 10⁷cm⁻².

5. A method of fabricating a laser diode based on AlInGaN alloy, consisting in epitaxial growth of a layer structure consisting of at least one bottom cladding layer of n-type conductivity comprising at least one GaOₓN₁₋ₓ layer (1, 1a, 1c) in which x>0.0005, a bottom waveguide layer of n-type conductivity, a light emitting layer, an electron blocking layer of p-type conductivity and an acceptor-doped subcontact layer with concentrations above 10²⁰cm⁻³, in which at least one layer is grown using a high pressure method of nitride solution in gallium at pressures of 800 MPa, **characterized in that** the bottom cladding layer (1a, 1b, 1c) is fabricated as three layer structure comprising two layers (1a, 1c) of GaOₓN₁₋ₓ deposited on the middle (inner) layer (1b) of gallium nitride of thickness of 100 to 400 µm, using the high pressure method of nitride solution in gallium at pressures of 800 MPa.

6. The method according to Claim 5, **characterized in that** the fabricated three layer structure of the bottom cladding layer (1a, 1b, 1c) the upper layer (1a), made of GaOₓN₁₋ₓ is at least 10 µm thick, and the bottom layer (1c), made of GaOₓN₁₋ₓ is of 2 to 100 µm thick.

## Patentansprüche

1. Eine Laser-Diode auf der Basis der AlInGaN Legierung, welche wie folgt enthält: eine bodenverkleidende Schicht (1) vom n-Typ Leitvermögen aus GaOₓN₁₋ₓ Legierung in welcher x>0.0005, eine Boden-Wellenleiter-Schicht (3a) vom n-Typ Leitvermögen, eine lichtemittierende Schicht (4a, 5, 4b), eine elektronblockierende Schicht (6) vom p-Typ Leitvermögen, eine obere Wellenleiter-Schicht (3b) vom p-Typ Leitvermögen eine obere verdeckende Schicht (2b) vom p-Typ Leitvermögen, und eine Subkontakt-Schicht (7), mit Dotierung von einem Konzentrationsniveau über 10²⁰cm⁻³, **gekennzeichnet dadurch, daß** die Dicke der bodenverkleidende Schicht (1) mindestens 10 µm ist, und das Material der bodenverkleidende Schicht (1) eine Brechungsindex mindestens um 1 % niedriger (bei einer Wellenlänge v. 405 nm) aufweist, als die Brechungsindex des Materials, das die Boden-Wellenleiter-Schicht (3a) und die obere Wellenleiter-Schicht (3b) bildet.

2. Die Laser-Diode gemäß Anspruch 1, **dadurch gekennzeichnet, daß** sie die erste zusätzliche Schicht (2a) von einer Dicke nicht weniger als 0.8 µm, aus der Al_{y}Ga_{1-y}N Legierung für welche 0<y<1, aufweist, wobei diese Schicht (2a) zwischen der bodenverkleidende Schicht (1) und die Boden-Wellenleiter Schicht (3a) liegt.

3. Die Laser-Diode gemäß Anspruch 1 oder 2, **dadurch gekennzeichnet, daß** sie zwei zusätzliche Schichten, die zweite (1a) und die dritte (1c) enthält, die unter die Bodenverkleidungsschicht (1) liegen und dadurch, dass unmittelbar unter der Bodenverkleidungsschicht (1) eine zweite zusätzliche Schicht (1a) aus Impfkristall vom Galliumnitride von einer Dicke zwischen 100 bis 400 µm befindlich ist, wobei unmittelbar darunter sich eine dritte zusätzliche Schicht (1c) 2 bis 100 µm stark aus GaOₓN₁₋ₓ in welcher x>0.0005 befindet.

4. Die Laser-Diode gemäß Anspruch 3 **dadurch gekennzeichnet, daß** die zweite (1a) und die dritte (1c) zusätzliche Schicht die Versetzungsdichte weniger als 1 x 107cm² aufweisen.

5. Methode für Produktion eine auf AlInGaN Legierung basierende Laser Diode bestehend in Epitaxiewachstum einer Schichtstruktur die mindestens aus einer Bodenverkleidungschicht vom n-Typ Leitvermögen besteht, die mindestens aus einer aus GaOₓN₁₋ₓ Schicht (1, 1a, 1c) in welcher x>0.0005, aus einer Boden-Wellenleiter-Schicht vom n-Typ Leitvermögen, aus einer lichtemittierenden Schicht, aus einer elektronblockierenden Schicht vom p-Typ Leitvermögen, und aus einer akzeptordotierten Sub-Kontakt-Schicht von Konzentrationen mehr als 10²⁰cm⁻³ besteht, bei welchen (Schichten) mindestens eine Schicht mit Hilfe von einer Hochdruck-Methode mit Nitrid-Lösung in Gallium bei einem Druck von 800 MPa wächst, **dadurch gekennzeichnet, daß** die Bodenverkleidungsschicht (1a, 1b, 1c) als eine 3-Schicht-Struktur hergestellt wird und zwei Schichten (1a, 1c) aus GaOₓN₁₋ₓ aufweist, wobei diese 2 Schichten auf der Mittelschicht (1b) von Gallium Nitride 100 bis 400 µm stark mit Hilfe von einer Hochdruck-Methode von Nitride-Lösung in Gallium bei 800 MPa Druck aufgetragen sind.

6. Methode gemäß Anspruch 5 **dadurch gekennzeichnet, daß** in der hergestellten 3-Schichten-Struktur der Bodenverkleidungschicht (1 a, 1 b, 1 c) die obere Schicht (1a) aus GaOₓN₁₋ₓ wenigstens 10 µm stark ist, und die Bodenschicht (1c) aus GaOₓN₁₋ₓ 2 bis 100 µm stark ist.

## Revendications

1. Diode laser à base d'alliage AlInGaN, comprenant une couche de revêtement infeérieure (1) de conductivité de type n en GaOₓN₁₋ₓ où x>0.0005, une couche de guide d'ondes inférieure (3a) de conductivité de type n, une couche émettrice de lumière (4a,5,4b), une couche de blocage d'électrons (6) de conductivité de type p, une couche de guide d'ondes supérieure (3b) de conductivité de type p, une couche de revêtement supérieure (2b) de conductivité de type p et une couche de subcontact (7), dopée avec des accepteurs avec un niveau de concentration supérieure à 10²⁰cm⁻³, **caractérisée en ce que** l'épaisseur de la couche de revêtement inférieure (1) est d'au moins 10 µm et que le matériau de la couche de revêtement inférieure (1) possède un indice de réfraction d'au moins un pour cent inférieur (à la longueur d'onde de 405 nm) à l'indice de réfraction du matériau constituant la couche inférieure de guide d'ondes (3a) et la couche supérieure (3b) de guide d'ondes.

2. La diode laser concernée par l'une des revendications 1, **caractérisée en ce qu'elle** comprend une première couche supplémentaire (2a) d'une épaisseur supérieure à 0.8 µm en alliage Al_{y}Ga_{1-y}N où 0<y<1 et qu'elle se situe entre la couche de revêtement inférieure (1) et la couche de guide d'ondesinférieure (3a).

3. La diode laser concernée par la revendication 1 ou 2, **caractérisée en ce qu'elle** comprend deux couches supplémentaires : la deuxième (1a) et la troisième couche (1c) situées au-dessous de la couche de revêtement inférieure (1) et que directement sous la couche de revêtement inférieure (1) il se trouve une deuxième couche supplémentaire (1a) en nitrure de gallium d'une épaisseur de 100 à 400 µm et directement sous celle-ci il y a une troisième couche supplémentaire (1 c) d'une épaisseur de 2 à 100 µm GaOₓN₁₋ₓ où x>0.0005.

4. La diode laser concernée par la revendication **3, caractérisée en ce que** la deuxième (1a) et la troisième couche supplémentaire (1c) ont une densité de dislocation inférieure à 1 x 10⁷cm².

5. Procédé de fabrication de la diode laser à base d'alliage AlInGaN, consiste à former épitaxialement une structure en couches, composée d'au moins une couche de revêtement inférieure de conductivité de type n comportant au moins une couche en GaOₓN₁₋ₓ (1, 1a, 1c) où x>0.0005, une couche de guide d'ondes inférieure de conductivité de type n, une couche émettrice de lumière, une couche de blocage d'électrons de conductivité de type p et une couche de subcontact accepteur dopée avec une concentration supérieure à 10²⁰cm⁻³ dans laquelle au moins une couche est réalisée suivant le procédé de nitruration à une pression supérieure à 800 MPa, **caractérisé en ce que** la couche de revêtement inférieure (1a, 1b, 1c) est réalisée en tant que structure à trois couches composée de deux couches (1a, 1c) en GaOₓN₁₋ₓ déposées sur la couche intermédiaire (1b) de nitrure de gallium d'une épaisseur de 100 à 400 µm, au moyen du procédé de nitruration à une pression supérieure à 800 MPa.

6. Le procédé concerné par la revendication 5 **caractérisé en ce que** dans la structure à trois couches de la couche de revêtement inférieure (1a, 1b, 1c), la couche supérieure (1a) en GaOₓN₁₋ₓ a au moins une épaisseur de 10 µm et que la couche de fond (1c) en GaOₓN₁₋ₓ a une épaisseur de 2 à 100 µm.
